Europäisches Patentamt

European Patent Office

Office européen des brevets

(19)

(11) **EP 0 720 262 B1**

(12) **FASCICULE DE BREVET EUROPEEN**

(45) Date de publication et mention
de la délivrance du brevet:
**17.02.1999 Bulletin 1999/07**

(51) Int Cl.$^6$: **H01S 3/103**, H01S 3/025,
H01S 3/085

(21) Numéro de dépôt: **95402843.7**

(22) Date de dépôt: **18.12.1995**

(54) **Composant laser à réflecteur de Bragg en matériau organique et procédé pour sa réalisation**

Laservorrichtung mit organischem Bragg-Reflektor und Herstellungsverfahren

Laser device with organic Bragg reflector and fabrication method

(84) Etats contractants désignés:
**DE FR GB**

(30) Priorité: **20.12.1994 FR 9415314**

(43) Date de publication de la demande:
**03.07.1996 Bulletin 1996/27**

(73) Titulaire: **FRANCE TELECOM**
**75015 Paris (FR)**

(72) Inventeur: **Bouadma, Nouredine**
**F-94250 Gentilly (FR)**

(74) Mandataire: **Martin, Jean-Jacques et al**
**Cabinet REGIMBEAU**
**26, Avenue Kléber**
**75116 Paris (FR)**

(56) Documents cités:
**EP-A- 0 502 682**

- **IEEE PHOTONICS TECHNOLOGY LETTERS, vol. 3, no. 4, Avril 1991 NEW YORK US, pages 299-301, XP 000227561 M. ÖBERG ET AL 'A Three electrode DBR laser with 22 nm wavelength tuning range'**
- **IEEE PHOTONICS TECHNOLOGY LETTERS, vol. 5, no. 6, 1 Juin 1993 pages 608-610, XP 000384042 KAMEDA T ET AL 'A DBR LASER EMPLOYING PASSIVE-SECTION HEATERS, WITH 10.8 NM TUNING RANGE AND 1.6 MHZ LINEWIDTH'**
- **IEEE PHOTONICS TECHNOLOGY LETTERS, vol. 6, no. 10, Octobre 1994 pages 1188-1190, XP 000476937 BOUADMA N ET AL 'INTEGRATION OF A LASER DIODE WITH A POLYMER-BASED WAVEGUIDE FOR PHOTONIC INTEGRATED CIRCUITS'**
- **IEEE JOURNAL OF QUANTUM ELECTRONICS, vol. 27, no. 3, Mars 1991 NEW YORK US, pages 778-787, XP 000227524 E. VAN TOMME ET AL 'Integrated optic devices based on non-linear optical polymers'**

## Description

La présente invention est relative à un composant laser à réflecteur de Bragg, ainsi qu'à un composant monolithique intégrant un tel composant. Elle concerne également un procédé pour la réalisation d'un tel composant.

L'invention trouve avantageusement application dans le domaine des télécommunications par fibres optiques et plus particulièrement pour les liaisons multiplexées en longueur d'onde ou les systèmes cohérents.

Depuis quelques années, un intérêt sans cesse croissant a été accordé au laser semi-conducteur à réflecteur de Bragg (DBR), notamment pour des applications dans les liaisons multiplexées (WDM) et pour les futurs systèmes cohérents. Les lasers DBR constituent en effet des sources à cohérences temporelles élevées (faible largeur de raie), qui présentent une accordabilité de longueur d'onde d'émission, qui peut être importante.

Un laser à réflecteur de Bragg est une structure laser monolithique intégrant, à l'extrémité d'un milieu amplificateur semi-conducteur (section active), un guide optique passif, dans lequel est réalisé un réseau constituant un réflecteur de Bragg (section de Bragg). Le guide optique passif peut présenter une partie dépourvue de réseau, interposée entre le milieu amplificateur et le réseau réflecteur, qui définit sur la structure DBR une section de contrôle de phase. Cette section permet d'éviter le saut de modes pendant l'accordabilité de la section DBR.

Généralement, l'accordabilité en longueur d'onde d'un tel laser DBR est réalisée par injection de courant dans les sections de Bragg ou d'adaptation de phase. L'injection de porteurs minoritaires permet en effet de faire varier l'indice de réfraction du milieu et donc de contrôler la longueur d'onde $\lambda_B$ de Bragg donnée par la formule $\lambda_B = \Lambda/2n_{eff}$, où $\Lambda$ est le pas du réseau et n est l'indice effectif du milieu.

Pour une présentation plus détaillée des lasers DBR, on pourra avantageusement se référer à la publication :

- "A theorical model of multielectrode DBR lasers" - X. Pan, H. Olesen, B. Tromborg - IEE - Journal of quantum electronics - Vol. 24, N° 12, december 1988.

Malgré des progrès importants dans les techniques de réalisation des composants semi-conducteurs, la fabrication d'un laser à réflecteur de Bragg reste complexe et nécessite de nombreuses étapes de croissance et de gravure. La maîtrise du couplage entre la section amplificatrice et la section guide, ainsi que le choix de la structure latérale du guide et son confinement électrique et optique sont d'une grande importance pour les performances du composant réalisé.

En outre, si les techniques d'accordabilité par injection de courant présentent l'avantage de permettre d'accéder à des grandes plages d'accordabilité (10 à 12 nm), elles sont néanmoins à l'origine d'un élargissement spectral important, ainsi que d'une diminution de la puissance émise. Ces phénomènes sont liés aux fluctuations de la concentration en porteurs dues à l'émission spontanée dans la section passive.

Récemment, il a été proposé d'accorder en longueur d'onde des lasers DBR par un chauffage localisé de leur section passive, ce chauffage étant obtenu, soit en injectant un courant inverse dans la section guidante, soit en utilisant des résistances chauffantes en couche mince.

On pourra à cet égard avantageusement se référer aux deux publications suivantes :

- "A Three-Electrode Distributed Bragg Reflector Laser with 22 nm Wavelength Tuning Range" - M. Oberg et al, IEEE Photonics Technology Letters, Vol. 3, NO, 4, Avril 1991,
- "A DBR laser Tunable by Resistive Heating" - S.L. Woodward et al, IEEE Photonics Technolog Letters, Vol. 4, NO 12, Decembre 1992.

Cependant, aucune de ces deux techniques d'accordabilité par chauffage n'est satisfaisante.

Dans les deux cas, le chauffage de la section guide n'est pas parfaitement localisé et induit une élévation de température de la section active amplificatrice qui se traduit par une dégradation des caractéristiques du laser (courants de seuil plus élevés, rendements quantiques plus faibles).

En outre, la solution mettant en oeuvre des courants inverses engendre, au niveau des jonctions électriques de la section guidante, des dommages qui diminuent les performances du composant.

Un but de l'invention est de proposer un composant qui pallie ces différents inconvénients.

A cet effet, l'invention propose un composant laser à réflecteur de Bragg comportant un substrat, qui porte, d'une part, une section active d'émission en matériaux semi-conducteurs et, d'autre part, un guide d'onde à réflecteur de Bragg prolongeant cette section active, des moyens permettant de faire varier l'indice de réfraction du guide d'onde, pour contrôler l'accordabilité en longueur d'onde dudit composant laser, caractérisé en ce que ledit guide d'onde est en matériau(x) organique(s).

Un tel composant est d'une fabrication simple, les matériaux organiques étant faciles à travailler : dépôt et gravure aisés ; réalisation des réseaux de Bragg par gravure directe ou photo-inscription sur le guide.

On notera également que les pertes dans la partie guide d'onde d'un tel composant sont faibles (inférieures à 1 dB/cm pour les longueurs d'onde d'émission des émetteurs lasers destinés aux télécommunications optiques (1,3 et 1,55 μm)).

L'accordabilité du composant peut être réalisée par effet thermooptique, ce qui permet de réduire les effets d'élargissement de raie et de perte de puissance émise observés dans le cas de l'accordabilité par injection.

Dans ce cas, le réseau de Bragg peut être lui aussi obtenu par effet thermooptique. Le composant comporte alors un réseau de résistances chauffantes qui induisent sur le guide d'onde un réseau d'indice de réfraction.

Les matériaux organiques présentent, par rapport aux matériaux semi-conducteurs, l'avantage d'être d'une plus faible conductivité thermique, de sorte que les perturbations thermiques induites par l'échauffement de la section de Bragg (et le cas échéant de la section de contrôle de phase) sur la section active sont réduites.

Les matériaux organiques du guide d'onde sont notamment préférentiellement choisis de façon à présenter une conductivité thermique faible, de préférence de l'ordre de ou inférieure à 1 W/(m.°K) (contre environ 70 W/(m.°K) pour les semi-conducteurs) et un coefficient (dn/dT) de variation d'indice de réfraction en fonction de la température élevée, de préférence supérieur à $10^{-4}°C^{-1}$.

En variante, l'accordabilité du composant peut être obtenue en utilisant l'effet électro-optique.

Un autre objet de l'invention est un composant monolithique intégrant au moins un composant laser à réflecteur de Bragg du type précité. Avantageusement alors, au moins un guide optique organique intégré prolonge la section de Bragg du composant laser.

Un autre objet encore de l'invention est un procédé pour la réalisation d'un tel composant laser. Ce procédé est caractérisé par les différentes étapes suivantes :

- on réalise, par croissance épitaxiale sur le substrat, un empilement de couches semi-conductrices correspondant à la structure de la section active ;
- on réalise, par gravure et reprise d'épitaxie, la structure latérale de cette section active ;
- on réalise, par masquage et gravure sèche jusqu'au substrat, un sillon dans la structure ainsi obtenue ;
- on dépose une couche antireflet en un matériau diélectrique dans le fond et les bords du sillon, ainsi que sur la face de sortie de la section active ;
- on dépose sur cette couche antireflet une couche de confinement en un matériau organique présentant un indice de réfraction plus faible que celui du coeur du guide ;
- on dépose sur cette couche de confinement une couche d'un matériau organique correspondant au coeur du guide;
- on réalise une gravure en ruban sur les couches organiques ainsi déposées ;
- on réalise le cas échéant le réseau de Bragg sur le ruban correspondant au coeur du guide ;

- on dépose sur le ruban et sur la couche antireflet une couche de confinement supérieure en un matériau organique présentant un indice de réfraction plus faible que celui du coeur du guide,
- on dépose sur cette couche de confinement une couche diélectrique de protection,
- on dépose sur cette couche diélectrique des couches formant résistances de chauffages.

Selon un mode de mise en oeuvre avantageux, on réalise, après le dépôt de la première couche organique de confinement, une gravure de ladite couche pour dégager la face de sortie de la section active.

Les différentes étapes d'un tel procédé sont d'une mise en oeuvre simple.

On notera en outre qu'il est possible avec un tel procédé de caractériser et qualifier la section active en matériaux semi-conducteurs avant que le guide d'onde organique ne soit réalisé. Ceci permet un gain de temps et de coût par rapport aux lasers DBR "tout semi-conducteur", pour lesquels la section active ne peut être caractérisée et qualifiée qu'à la fin de la fabrication du composant.

D'autres caractéristiques et avantages de l'invention ressortiront encore de la description qui suit. Cette description est purement illustrative et non limitative. Elle doit être lue en regard des dessins annexés sur lesquels :

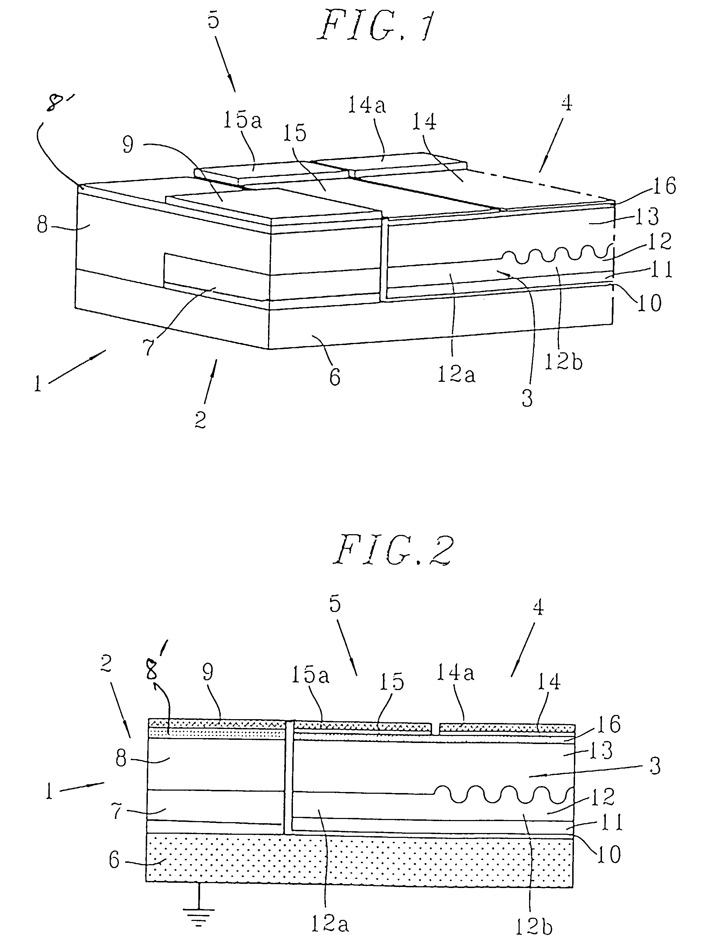

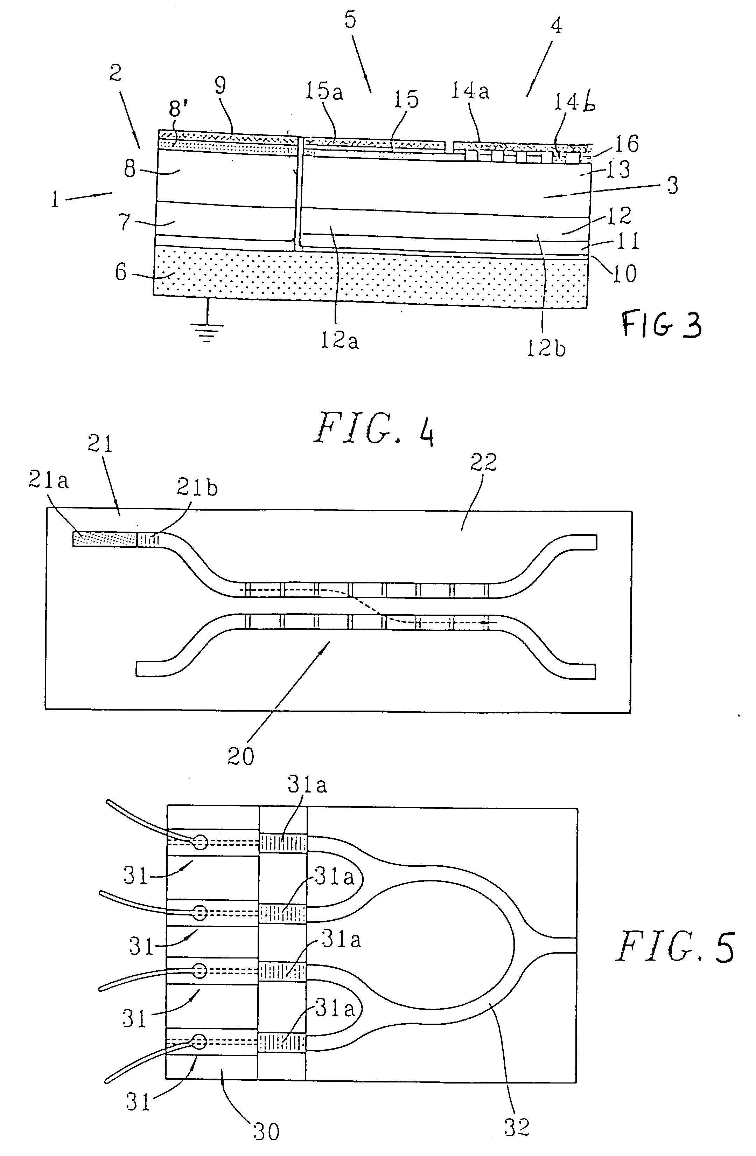

. la figure 1 est une demi-vue en perspective d'un composant conforme à l'invention ;
. la figure 2 est une représentation schématique en coupe longitudinale du composant de la figure 1 ;
. la figure 3 est une représentation semblable à celle de la figure 2 d'une autre variante possible pour l'invention ;
. les figures 4 et 5 représentent schématiquement deux composants monolithiques intégrant un composant selon l'invention.

Le composant laser représenté sur les figures 1 et 2 a été référencé de façon générale par 1 et comporte une section amplificatrice laser 2 prolongée par un guide d'onde 3. Ce guide d'onde 3 comporte une section de Bragg 4 et une section de contrôle de phase 5 interposée entre la section amplificatrice 2 et la section de Bragg 4.

Ce composant monolithique 1 présente un substrat 6 d'InP dopé n ou semi-isolant SI commun aux différentes sections 2, 4 et 5. Ce substrat 6 est relié électriquement à la tension neutre.

La section amplificatrice 2 comprend une couche de confinement en matériau semiconducteur de type InP-n, une couche active 7 en un matériau semi-conducteur, tel que GaInAsP massif ou en puits quantiques, déposée sur InP-n et recouverte d'une couche 8 d'InP dopé p. Sur la face de la couche 8 qui est opposée au substrat 6 sont déposées une couche de contact 8' en matériau tel que GaInAs et une électrode 9, qui permet l'alimentation de la couche active 7 par un courant d'amplification.

Le guide d'onde 3 est en un matériau organique et est déposé sur une couche mince 10 antireflet portée par le substrat 6 et sur la face de la section amplificatrice.

Plus particulièrement, ce guide d'onde 3 est défini par :

- une couche organique 11 de confinement, de 1,5 μm d'épaisseur, déposée sur la couche antireflet 10, cette couche 11 présentant un indice de réfraction n1 ;
- une couche organique 12 de 1 μm d'épaisseur, constituant le coeur du guide 3, cette couche 12 étant déposée sur la couche 11 et présentant un indice de réfraction n2 supérieur à n1 ;
- une couche organique 13 de confinement supérieur, qui recouvre les couches 12 et 11, cette couche organique 13 de confinement supérieur présentant un indice de réfraction n3 inférieur à n1 et une épaisseur variant entre 1,5 et 2 μm.

Les matériaux organiques de la couche 12 sont avantageusement choisis parmi les polystyrènes (poly(méthacrylate de méthyle) par exemple), les polysiloxanes, les polysulfones, les polyimides fluorés, les polyimides deutérés (substitution partielle d'atomes d'hydrogène par des atomes de deutérium). Ces différents matériaux sont transparents pour une large gamme de longueurs d'onde inférieures à 1,6 μm.

La couche 12 présente au niveau de la section 5 de contrôle de phase une partie non gravée 12a et au niveau de la section 4 de Bragg une partie gravée 12b, qui définit avec la couche 13, le réseau constituant le réflecteur de Bragg.

La face de la couche 13 opposée au substrat 6 porte, au niveau de la section de Bragg 4 et de la section de contrôle de phase 5, un ruban 14 et un ruban 15 formant résistances de chauffage.

Ces rubans 14 et 15 sont déposés sur une couche diélectrique 16 interposée entre lesdits rubans et la couche 13.

Ces rubans 14 et 15 formant résistances de chauffage sont chacun commandés par une paire d'électrodes 14a, 15a (une seule électrode de chaque paire étant représentée sur les figures). Les deux électrodes 14a, 15a d'une même paire sont disposées de part et d'autre du guide d'onde 3. Les tensions commandées par l'intermédiaire de ces électrodes aux bornes de ces rubans 14 et 15 sont indépendantes et sont fonction des températures que l'on souhaite imposer aux sections 4 et 5.

On contrôle ainsi par effet thermooptique les indices de réfraction du matériau organique du guide d'onde 3, d'une part, au niveau de la section 5 et, d'autre part, au niveau de la section 4, c'est-à-dire la phase et la longueur d'onde de la lumière émise.

En particulier, la variation de longueur d'onde de Bragg λB que permet une variation de température ΔT est donnée par :

$$\Delta\lambda B/\lambda B = \Gamma(dn/dT)\Delta T,$$

où $\Gamma(dn/dT)$ est le coefficient de confinement du guide, soit pour une longueur d'onde d'émission de 1,55 μm, pour une variation de température ΔT de 80°C, et pour $\Gamma = 0,8$ et $dn/dT = 2.10^{-4}$, une accordabilité de 12,6 nm.

La puissance nécessaire pour cette variation de température est de :

$$P = V^2/R = \frac{L.d.k\,(1 + 0{,}88e/d)}{e}\,\Delta T$$

où V est la tension aux bornes de la résistance chauffante 14, où R est la valeur ohmique de cette résistance, L et d sont ses longueur et largeur, e est l'épaisseur totale de la couche organique et k est la conductivité thermique du milieu organique.

Pour l'exemple représenté sur les figures 1 et 2, on a :

L = 100 μm, d = 50 μm, e = 4 μm, ΔT = 80°K, k = 0,17 W/(m.°K) et R =5 kΩ,

ce qui correspond à une puissance P de 1,8 mW et à une tension V de 3 Volts.

La fabrication du composant laser 1 qui vient d'être décrit s'effectue en mettant en oeuvre la succession d'étapes suivantes :

1) On réalise un empilement de couches semi-conductrices correspondant à la structure de la section amplificatrice 2 par croissances épitaxiales sur le substrat 6, en mettant en oeuvre les techniques de croissances épitaxiales classiques : épitaxie liquide, épitaxie vapeur aux organométalliques (OMCVD), épitaxie par jet moléculaire (MBE), la structure de la couche active pouvant être de type massif ou à puits quantiques.

2) On réalise la structure latérale de la section active 2, de façon à obtenir une structure de type laser enterré, en mettant en oeuvre sur l'empilement obtenu un traitement de gravure, puis une reprise d'épitaxie (croissance de la couche 8 et de la couche 8').

3) On amincit le substrat et on métallise les deux faces de l'échantillon obtenu.

4) On réalise un sillon transversal de 4 à 5 μm de profondeur dans les couches semi-conductrices, par masquage et gravure jusqu'au substrat 6, en utilisant une méthode de gravure sèche (par exemple des techniques de gravure du type de celles classiquement connues sous les dénominations RIE, RIBE, CAIBE), de façon à obtenir dans le semi-conducteur une face lisse et verticale qui constitue la face de sortie de la section amplificatrice 2.

5) On dépose dans le fond du sillon ainsi réalisé et sur la face de sortie de la section amplificatrice la couche antireflet 10, qui est en un matériau diélectrique, tel que SiO ou TiO2, l'épaisseur de cette couche 10 étant de λ/4n, où λ est la longueur d'onde centrale d'émission de la section amplificatrice 2, n est l'indice de réfraction dudit matériau diélectrique tel que n = √nsn2, où ns est l'indice de réfraction du semi-conducteur formant la zone active.

6) On dépose ensuite sur toute la surface du sillon, par centrifugation par exemple, la couche 11 organique de confinement d'épaisseur 1,5 µm (par exemple le PMHA polyméthylméthacrylate).

7) Par gravure (photographie aux ultraviolets profonds dans le cas où le matériau organique est le PMMA), on dégage la face verticale de sortie de la section active 2 et le haut de la section 2.

8) On réalise un fluage du matériau organique déposé par élévation de température (200°C pendant 20 minutes, pour le PMMA) de façon à uniformiser l'épaisseur dudit matériau dans le fond du sillon.

9) On dépose par centrifugation la couche organique d'indice n2 correspondant au coeur 12 du guide (par exemple le polystyrène).

10) On réalise une gravure sèche (RIE oxygène) à travers un masquage métallique ou diélectrique dans les deux couches organiques ainsi déposées, de façon à définir la largeur du guide (2 µm), le ruban organique ainsi réalisé étant dans le prolongement exact de la couche active 7.

11) On réalise le réseau de Bragg sur ce ruban organique, à une distance donnée de la face de sortie de la section active 2. Ce réseau de Bragg peut être par exemple réalisé par gravure directe à travers un masquage holographique classique, ou par inscription photoréfractive dans le guide consistant à irradier la partie supérieure du guide par un système de franges d'interférences, ou encore par écriture photochimique à l'aide d'un laser.

12) On dépose par centrifugation sur tout le sillon la couche de confinement optique supérieure 13 (par exemple le téflon (marque déposée) amorphe ou le matériau commercialisé sous la dénomination commerciale polymatrif, ou du PMMA dans le cas où le matériau de coeur est du polysulfone).

13) On dépose sur toute la surface du matériau organique, une couche diélectrique de protection 16 en un matériau tel que $SiO_2$ ou $Si_3N_4$.

14) On dépose au droit des parties 12a et 12b les couches 14 et 15, formant résistance de chauffage. Ces couches 14 et 15 étant par exemple des couches d'une épaisseur de l'ordre de 1000 Å d'or, de platine, de titane ou de chrome.

L'échantillon ainsi obtenu est ensuite découpé en plusieurs puces formant le composant représenté sur la figure 1.

En variante, ainsi qu'illustré sur la figure 3, le réseau de Bragg peut être constitué non pas par gravure de la couche 12, mais au moyen d'un réseau de résistances chauffantes 14b remplaçant la résistance 14. Ce réseau induit par effet thermooptique un réseau d'indice de réfraction au niveau du guide d'onde organique, dont le coefficient de couplage dépendra de la tension appliquée sur les résistances chauffantes 14b.

Bien entendu, la structure qui vient d'être décrite peut être intégrée dans des composants monolithiques présentant d'autres fonctions que la seule fonction d'émission laser.

En particulier, ainsi qu'on l'a illustré sur la figure 4, cette structure peut être intégrée dans un composant laser à filtre organique comportant, sur un même substrat 22, un coupleur directionnel 20 à guides d'onde organiques et un laser DBR 21, du type de celui décrit en référence aux figures 1 à 3, dont la section de Bragg est prolongée par l'une des branches du coupleur 20. Sur la figure 4, la section active du laser 21 a été référencée par 21a, la section de Bragg par 21b.

Egalement, ainsi qu'illustré sur la figure 5, les lasers DBR organiques du type de ceux qui ont été décrits en référence aux figures 1 à 3, peuvent être intégrés pour constituer des barrettes 30 de N lasers 31. Les sections de Bragg 31a des lasers 31 sont avantageusement prolongées par des guides d'onde en matériaux organiques d'une section de couplage 32 à N entrées. Sur la figure 5, cette section 32 constitue un combineur à N entrées et une sortie.

D'autres fonctions optiques sont bien entendu possibles en sortie de la barrette. La section 32 peut en particulier être remplacée par une matrice de commutation à N entrées et N sortie, constituée de N coupleurs directifs.

Avantageusement, lors de la fabrication de tels composants intégrant des lasers DBR et d'autres fonctions, on dépose simultanément les couches organiques du ou des lasers DBR et celles des guides d'onde qui le ou les prolongent.

D'autres variantes de l'invention sont bien entendu possibles. En particulier, le coeur du guide d'onde peut être en un matériau organique électro-optique à propriété optique non linéaire (NLO) (tel que par exemple les polyimides dopés ou greffés), le composant laser DBR comportant à la place des résistances de chauffage du composant des figures 1 et 2, des électrodes permettant d'appliquer au guide d'onde un champ électrique destiné à faire varier l'indice de réfraction de son coeur.

**Revendications**

1. Composant laser à réflecteur de Bragg comportant un substrat (6), qui porte, d'une part, une section active d'émission (2) en matériaux semi-conducteurs et, d'autre part, un guide d'onde (3) à réflecteur de Bragg prolongeant cette section active (2), des moyens (14, 15, 14a, 15a) permettant de faire varier l'indice de réfraction du guide d'onde (3), pour contrôler l'accordabilité en longueur d'onde dudit composant laser, caractérisé en ce que ledit guide d'onde (3) est en matériau(x) organique(s).

2. Composant selon la revendication 1, caractérisé en ce que le guide d'onde (3) est en matériau(x) organique(s) thermo-optique(s) et en ce que les moyens (14, 15, 14a, 15a) permettant de faire varier l'indice de réfraction du guide d'onde comportent des moyens pour chauffer sa section à réflecteur de Bragg.

3. Composant selon la revendication 2, caractérisé en ce qu'il comporte un réseau de résistances chauffantes (14b) qui induisent sur le guide d'onde un réseau d'indices de réfraction.

4. Composant selon l'une des revendications 2 ou 3, caractérisé en ce que le (ou les) matériau(x) organique(s) du guide d'onde (3) présente(nt) une conductivité thermique faible de préférence de l'ordre de ou inférieure à 1 W/(m.°K) et un coefficient de variation d'indice de réfraction en fonction de la température élevée, de préférence supérieur à $10^{-4}°C^{-1}$.

5. Composant selon la revendication 1, caractérisé en ce que le coeur du guide d'onde est en un matériau organique électro-optique et en ce que les moyens permettant de faire varier l'indice de réfraction du guide d'onde comportent des moyens pour appliquer un champ électrique audit guide d'onde.

6. Composant selon l'une des revendications précédentes, caractérisé en ce que le (ou les) matériau(x) organique(s) est (ou sont) choisi(s) parmi les polystyrènes, les polysiloxanes, les polyimides fluorés, les polyimides deutérés.

7. Composant selon l'une des revendications précédentes, caractérisé en ce que le guide d'onde organique (3) comporte une partie (5) sans réseau, intercalée entre la section de Bragg (4) et la section active (2), cette partie sans réseau correspondant à la section de contrôle de phase du composant.

8. Composant monolithique intégrant au moins un composant laser à réflecteur de Bragg (21, 31) selon l'une des revendications précédentes.

9. Composant monolithique selon la revendication 8, caractérisé en ce qu'au moins un guide optique organique intégré prolonge la section de Bragg du composant laser.

10. Procédé pour la réalisation d'un composant selon l'une des revendications 1 à 9, caractérisé par les différentes étapes suivantes :

- on réalise, par croissance épitaxiale sur le substrat (6), un empilement de couches semiconductrices correspondant à la structure de la section active (2) ;
- on réalise, par gravure et reprise d'épitaxie, la structure latérale (8) de cette section active ;
- on réalise, par masquage et gravure sèche jusqu'au substrat (6), un sillon dans la structure ainsi obtenue;
- on dépose une couche antireflet (10) en un matériau diélectrique dans le fond et les bords du sillon, ainsi que sur la face de sortie de la section active ;
- on dépose sur cette couche antireflet (10) une couche de confinement (11) en un matériau organique présentant un indice de réfraction plus faible que celui du coeur du guide ;
- on dépose sur cette couche de confinement (11) une couche d'un matériau organique correspondant au coeur (12) du guide ;
- on réalise une gravure en ruban sur les couches (11, 12) organiques ainsi déposées ;
- on réalise le cas échéant le réseau de Bragg sur le ruban correspondant au coeur (12) du guide ;
- on dépose sur le ruban et sur la couche antireflet (10) une couche de confinement supérieure (13) en un matériau organique présentant un indice de réfraction plus faible que celui du coeur du guide ;
- on dépose sur cette couche de confinement une couche diélectrique de protection (16) ;
- on dépose sur cette couche diélectrique (16) des couches formant résistances de chauffages (14, 14b, 15).

11. Procédé selon la revendication 10, caractérisé en ce qu'on réalise, après le dépôt de la première couche organique de confinement, une gravure de ladite couche pour dégager la face de sortie de la section active.

**Patentansprüche**

1. Braggreflektor-Laserbauteil mit einem Substrat (6), welches einerseits einen aktiven Emissionsbereich (2) aus Halbleitermaterialien und andererseits einen diesen aktiven Bereich (2) verlängernden Braggreflektor-Wellenleiter (3), und Mittel (14, 15, 14a, 15a) trägt, die es ermöglichen, den Brechungsindex des Wellenleiters (3) zu variieren, um die Wellenlängenabstimmung des Laserbauteiles zu steuern, dadurch gekennzeichnet, daß der Wellenleiter (3) aus organischem(n) Material(ien) ist.

2. Bauteil nach Anspruch 1, dadurch gekennzeichnet, daß der Wellenleiter (3) aus thermo-optischem(n) organischem(n) Material(ien) ist und daß die Mittel (14, 15, 14a, 15a), die den Brechungsindex der Wellenleiter variieren können, Mittel zum Erwärmen ihres Braggreflektor-Bereiches aufweisen.

3. Bauteil nach Anspruch 2, dadurch gekennzeichnet, daß es ein Gitter von Heizwiderständen (14b) aufweist, die auf dem Wellenleiter ein Brechungsindex-Gitter induzieren.

4. Bauteil nach einem der Ansprüche 2 oder 3, dadurch gekennzeichnet, daß das (oder die) organische(n) Material(ien) des Wellenleiters (3) eine geringe thermische Leitfähigkeit, bevorzugt in der Größenordnung von oder kleiner als 1W/(m°K), und einen erhöhten Koeffizienten der Variation des Brechungsindex als Funktion der Temperatur, bevorzugt größer als $10^{-4}°C^{-1}$ aufweist (aufweisen).

5. Bauteil nach Anspruch 1, dadurch gekennzeichnet, daß der Kern des Wellenleiters aus einem elektrooptischen organischen Material ist und daß die Mittel, die den Brechungsindex des Wellenleiters variieren können, Mittel zum Anlegen eines elektrischen Feldes an den Wellenleiter aufweisen.

6. Bauteil nach einem der vorhergehenden Ansprüche, dadurch gekennzeichnet, daß das (oder die) organische(n) Material(ien) unter den Polystyrolen, den Polysiloxanen, den fluorierten Polyimiden, den deuterierten Polyimiden ausgewählt ist (oder sind).

7. Bauteil nach einem der vorhergehenden Ansprüche, dadurch gekennzeichnet, daß der organische Wellenleiter (3) einen Bereich (5) ohne Gitter aufweist, der zwischen dem Bragg-Bereich (4) und dem aktiven Bereich (2) angeordnet ist, und dieser Bereich ohne Gitter dem Phasensteuerungsbereich des Bauteils entspricht.

8. Monolithisches Bauteil, das wenigstens ein Braggreflektor-Laserbauteil (21, 31) nach einem der vorhergehenden Ansprüche integriert hat.

9. Monolithisches Bauteil nach Anspruch 8, dadurch gekennzeichnet, daß wenigstens ein integrierter organischer Lichtleiter den Braggbereich des Laserbauteils verlängert.

10. Verfahren für die Herstellung eines Bauteils nach einem der Ansprüche 1 bis 9, gekennzeichnet durch folgende verschiedene Schritte:

   - durch epitaktisches Aufwachsen auf dem Substrat (6) wird eine Aufeinanderschichtung von halbleitenden Schichten hergestellt, welche der Struktur des aktiven Bereichs (2) entsprechen;
   - durch Strukturieren und Wiederaufnahme der Epitaxie wird die laterale Struktur (8) dieses aktiven Bereiches hergestellt;
   - durch Maskieren und trochenes Strukturieren bis zu dem Substrat (6) wird ein Graben in der so erhaltenen Struktur hergestellt;
   - eine antireflektierende Schicht (10) aus einem dielektrischen Material wird auf dem Boden und den Wänden des Grabens aufgetragen, sowie auf der Ausgangsfläche des aktiven Bereiches;
   - auf dieser antireflektierenden Schicht (10) wird eine Begrenzungsschicht (11) aus einem organischen Material aufgetragen, welche einen geringeren Brechungsindex als denjenigen des Leiterkerns aufweist;
   - auf dieser Begrenzungsschicht (11) wird eine Schicht aus einem dem Kern (12) der Leiter entsprechenden organischen Material aufgetragen;
   - auf diesen so aufgetragenen organischen Schichten (11, 12) wird eine Streifenstrukturierung durchgeführt;
   - gegebenenfalls wird das Bragg-Gitter auf dem dem Kern (12) des Leiters entsprechenden Streifen hergestellt;
   - auf dem Streifen und auf der antireflektierenden Schicht (10) wird eine obere Begrenzungsschicht (13) aus einem organischen Material aufgetragen, das einen geringeren Brechungsindex als denjenigen des Leiterkerns aufweist;
   - auf dieser Begrenzungsschicht wird eine dielektrische Schutzschicht (16) aufgetragen;
   - auf dieser dielektrischen Schicht (16) werden die Heizwiderstände (14, 14b, 15) bildende Schichten aufgetragen.

11. Verfahren nach Anspruch 10, dadurch gekennzeichnet, daß nach Auftragen der ersten organischen Begrenzungsschicht eine Strukturierung der Schicht durchgeführt wird, um die Ausgangsfläche des aktiven Bereichs freizulegen.

**Claims**

1. A laser component having a Bragg reflector, the component comprising a substrate (6) carrying firstly an active emission section (2) of semiconductor materials and secondly a Bragg reflector waveguide (3) extending said active section (2), means (14. 15. 14a, 15a) enabling the refractive index of the waveguide (2) to be varied so as to control the wavelength tuning of said laser component. characterized in that said waveguide (3) is made of organic material(s).

2. A component according to claim 1. characterized in that the waveguide (3) is made of thermo-optical organic material(s), and in that the means (14. 15. 14a, 15a) enabling the refractive index of the waveguide to be varied comprise means for heating the Bragg reflector section thereof.

3. A component according to claim 2, characterized in that it includes an array of heating resistances (14b) which induce an array of refractive indices on the waveguide.

4. A component according to claim 2 or 3, characterized in that the organic material(s) of the waveguide (3) is/are of low thermal conductivity. preferably about or less than 1 W/(m.°K) and a large coefficient of refractive index variation as a function of temperature. preferably greater than $10^{-4}$°C$^{-1}$.

5. A component according to claim 1, characterized in that the core of the waveguide is made of an electro-optical organic material and in that the means enabling the refractive index of the waveguide to be varied comprise means for applying an electric field to said waveguide.

6. A component according to any preceding claim, characterized in that the organic material(s) is/are selected from: polystyrenes; polysiloxanes: fluorine-containing polyimides; and deuterium-containing polyimides.

7. A component according to any preceding claim, characterized in that the organic waveguide (3) includes a grating-free portion (5) interposed between the Bragg section (4) and the active section (2), said grating-free portion corresponding to the phase control section of the component.

8. A monolithic component integrating at least one Bragg reflector laser component (21. 31) according to any preceding claim.

9. A monolithic component according to claim 8, characterized in that at least one integrated organic light waveguide extends the Bragg section of the laser component.

10. A method of making a component according to any one of claims 1 to 9. characterized by the following steps:

a stack of semiconductor layers corresponding to the structure of the active section (2) is made on the substrate (6) by epitaxial growth; the lateral structure (8) of said active section is made by etching and repeating epitaxy; a furrow is made in the resulting structure by masking and dry etching down to the substrate (6); an antireflection layer (10) of dielectric material is deposited on the bottom and the sides of the furrow, and also on the outlet face of the active section; a confinement layer (11) of organic material having a refractive index smaller than that of the core of the waveguide is deposited on said antireflection layer (10); a layer of organic material corresponding to the core (12) of the waveguide is deposited on said confinement layer (11); a ridge is etched in the organic layers (11. 12) deposited in this way; where appropriate, the Bragg grating is made on the ridge corresponding to the core (12) of the waveguide; a top confinement layer (13) of an organic material having a refractive index that is smaller than that of the core of the waveguide is deposited on the ridge and on the antireflection layer (10); a dielectric protection layer (16) is deposited on said confinement layer; and layers forming heating resistances (14. 14b. 15) are deposited on said dielectric layer (16).

11. A method according to claim 10, characterized in that after the first organic confinement layer has been deposited. said layer is etched to clear the outlet face of the active section.

*FIG.1*

*FIG.2*

FIG 3

FIG. 4

FIG. 5